# EUROPEAN PATENT APPLICATION

(11) **EP 4 529 376 A1**
(43) Date of publication of application: **26.03.2025**
(21) Application number: 24175688.1
(22) Date of filing: 14.05.2024
(51) Int. Cl.: H05K 7/20, H02M 7/00

(54) **HEAT DISSIPATION STRUCTURE, POWER CONVERSION EQUIPMENT AND PHOTOVOLTAIC SYSTEM**

(30) Priority: 22.09.2023 CN 202322592261 U
(71) Applicant: Sungrow Power Supply Co., Ltd., Hefei, Anhui 230088 (CN)
(72) Inventor: PAN, Jiangling, Hefei, 230088 (CN); CHEN, Lin, Hefei, 230088 (CN); CHEN, Rui, Hefei, 230088 (CN)
(74) Representative: Epping - Hermann - Fischer

(57) **Abstract**

A heat dissipation structure, power conversion equipment and a photovoltaic system are provided. The heat dissipation structure includes an air duct back housing, a fan module and an air inlet mesh guard, where the air duct back housing is arranged at a back side of an enclosure of electrical equipment, and an air inlet opening is provided on the air duct back housing; the fan module is arranged in the air duct back housing, and the fan module has an air inlet face fitting the air inlet opening; and the air inlet mesh guard is arranged at the air inlet opening in a manner that mounting and dismounting of the air inlet mesh guard is able to be performed at an outer side of the air duct back housing. Thus, clearing for the heat dissipation structure can be performed without shutting down the electrical equipment.

## Description

### FIELD

The present application relates to the technical field of heat dissipation of equipment, and in particular to a heat dissipation structure, power conversion equipment and a photovoltaic system.

### BACKGROUND

To satisfy stable operation of electrical equipment, the electrical equipment generally has to be equipped with a heat dissipation structure. For example, photovoltaic or energy-storage power electrical equipment or the like is equipped with the heat dissipation structure to satisfy operation requirements. The most common heat dissipation structure at present employs air cooling heat dissipation, specifically, a fan is provided outside the electrical equipment, and the fan performs air cooling heat dissipation on electrical elements inside the electrical equipment.

During operation of the heat dissipation structure, the fan may suck willow catkins, aspen catkins, cotton, fluff and other matters into the air duct, which affects heat dissipation of the electrical equipment. Furthermore, the existing electrical equipment such as an inverter or the like is generally mounted by hanging on a wall or on a rack, and the air duct at the back side is difficult to be dismounted. In general, the air duct of the heat dissipation structure can only be opened to clear blockages only after the electrical equipment is shut down and dismounted, therefore operation for maintaining the air duct is cumbersome and power production is lost.

In summary, a technical problem to be solved by those skilled in the art is that the heat dissipation structure of the electrical equipment needs cumbersome operation for maintaining the air duct and causes loss of power production.

### SUMMARY

In view of this, a heat dissipation structure, power conversion equipment and a photovoltaic system are provided in the present application, to solve the problems of the heat dissipation structure of the electrical equipment that the operation for maintaining the air duct is cumbersome and the power production is lost.

To achieve the above object, the following technical solutions are provided according to the present application.

A heat dissipation structure includes:
an air duct back housing, configured to be arranged at a back side of an enclosure of electrical equipment, where an air inlet opening is provided on the air duct back housing;
a fan module, being arranged in the air duct back housing, where the fan module has an air inlet face fitting the air inlet opening; and
an air inlet mesh guard, being arranged at the air inlet opening in a manner that the air inlet mesh guard is allowed to be mounted and dismounted from an outer side of the air duct back housing.

In an embodiment, the air inlet mesh guard is arranged on a back wall of the air duct back housing in a detachable manner.

In an embodiment, the detachable manner of the air inlet mesh guard being arranged on the back wall includes one or a combination of at least two of three manners, namely a sliding fit manner by pushing and pulling in a plane where the air inlet mesh guard is located, a fixed connection manner by a fastener, and a clamping connection manner.

In an embodiment, the air inlet mesh guard is fitted with the back wall in the sliding fit manner that the air inlet mesh guard 6 is allowed to be pushed and pulled with respect to the back wall from a lateral portion of the air duct back housing in the plane where the air inlet mesh guard is located.

In an embodiment, a first slide groove and a second slide groove are provided on the back wall, an upper edge of the air inlet mesh guard is in a sliding fit with the first slide groove, and a lower edge of the air inlet mesh guard is in a sliding fit with the second slide groove.

In an embodiment, the fan module is arranged at the air duct back housing in a sliding fit manner that the fan module is allowed to be pushed and pulled in a plane where the air inlet mesh guard is located.

In an embodiment, the fan module is configured to be pulled out with respect to the air duct back housing toward a lateral portion of the air duct back housing.

In an embodiment, a first slideway and a second slideway are provided on the air duct back housing, a top portion of the fan module is in a sliding fit with the first slideway, and a bottom portion of the fan module is in a sliding fit with the second slideway.

In an embodiment, the lateral portion of the air duct back housing is provided with a pull-push opening, and a closing plate arranged at the pull-push opening in a detachable manner for closing the pull-push opening.

In an embodiment, the air inlet mesh guard is arranged at the air inlet face of the fan module, and is allowed to be pushed and pulled together with the fan module with respect to the air duct back housing.

In an embodiment, the fan module includes a fan support and at least one heat dissipation fan arranged on the fan support, where the air inlet mesh guard is arranged at the fan support and covers an air inlet side end face of the at least one heat dissipation fan.

In an embodiment, the air duct back housing includes a back housing main body, a top wall arranged at a top portion of the back housing main body, a bottom wall arranged at a bottom portion of the back housing main body, and a lateral wall arranged at a lateral portion of the back housing main body; where
the top wall and the back housing main body are connected in a detachable manner; and/or
the bottom wall and the back housing main body are connected in a detachable connection manner; and/or
the lateral wall and the back housing main body are connected in a detachable connection manner.

In an embodiment, at least one of the top wall, the bottom wall and the lateral wall is configured to be a ventilation mesh guard structure.

In an embodiment, the detachable connection manner between the top wall and the back housing main body includes one or a combination of at least two of three manners, namely a sliding fit manner by pushing and pulling, a fixed connection manner by a fastener, and a clamping connection manner; and/or
the detachable connection manner between the bottom wall and the back housing main body includes one or a combination of at least two of three manners, namely a sliding fit manner by pushing and pulling, a fixed connection manner by a fastener, and a clamping connection manner; and/or
the detachable connection manner between the lateral wall and the back housing main body includes one or a combination of at least two of three manners, namely a sliding fit manner by pushing and pulling, a fixed connection manner by a fastener, and a clamping connection manner.

Compared with the content described in the background, the above heat dissipation structure includes an air duct back housing, a fan module and an air inlet mesh guard, where the air duct back housing is arranged at a back side of an enclosure of electrical equipment, and an air inlet opening is provided on the air duct back housing; the fan module is arranged in the air duct back housing, and the fan module has an air inlet face fitting the air inlet opening; and the air inlet mesh guard is arranged at the air inlet opening in a manner that mounting and dismounting of the air inlet mesh guard can be performed at the outer side of the air duct back housing. In actual applications of the heat dissipation structure, even if the electrical equipment is mounted by hanging on a wall or on a rack, and the air duct back housing is mounted at the back side of the enclosure of the electrical equipment, since the air inlet mesh guard is arranged at the air inlet opening in the manner that mounting and dismounting of the air inlet mesh guard can be performed at the outer side of the air duct back housing, in a case that the heat dissipation structure needs to be cleared, there is no need to shut down the electrical equipment, instead, it is only needed to dismount the air inlet mesh guard for clearing. Hence, the operation is very simple, and loss of power production due to shut-down is prevented.

Moreover, power conversion equipment is further provided in the present application, including an enclosure and a heat dissipation structure arranged at a back side of the enclosure, where the heat dissipation structure is according to any one of the above solutions. Since the heat dissipation structure described hereinabove has the above technical effects, the power conversion equipment having the heat dissipation structure also has corresponding technical effects, which will not be described herein.

In addition, a photovoltaic system is further provided in the present application, including the power conversion equipment described in the above solution. Since the power conversion equipment has the above technical solutions, the photovoltaic system having the power conversion equipment also has corresponding technical effects, which will not be described herein.

### BRIEF DESCRIPTION OF THE DRAWINGS

For more clearly illustrating embodiments of the present application or the technical solutions in the conventional technology, drawings referred to describe the embodiments or the conventional technology will be briefly described hereinafter. Apparently, the drawings in the following description are only some examples of the present application, and for those skilled in the art, other drawings may be obtained based on these drawings without any creative efforts.
FIG. 1 is a schematic perspective view showing the structure of an air duct back housing mounted at a back side of an enclosure according to an embodiment of the present application;
FIG. 2 is a schematic perspective view showing the structure of the air duct back housing according to the embodiment of the present application viewing from an inner side thereof;
FIG. 3 is a schematic exploded view showing the structure of a top wall, a bottom wall and an air inlet mesh guard of the air duct back housing according to an embodiment of the present application viewing from an inner side of the air duct back housing;
FIG. 4 is a schematic exploded view showing the structure of the top wall, the bottom wall and the air inlet mesh guard of the air duct back housing according to the embodiment of the present application viewing from an outer side of the air duct back housing;
FIG. 5 is a schematic exploded view showing the structure of a top wall, a bottom wall, a fan module and an air inlet mesh guard of the air duct back housing according to an embodiment of the present application;
FIG. 6 is a schematic exploded view showing the structure of an air inlet mesh guard being dismounted together with a fan module from an air duct back housing according to an embodiment of the present application;
FIG. 7 is a schematic perspective view showing the structure of a fan module according to an embodiment of the present application from a first viewing angle;
FIG. 8 is a schematic perspective view showing the structure of the fan module according to the embodiment of the present application from a second viewing angle;
FIG. 9 is a schematic view showing the structure of a fan module mounted to an air duct main body of electrical equipment according to an embodiment of the present application;
FIG. 10 is a schematic view showing the separated structure of an acoustic panel and a housing wall of an air duct main body according to an embodiment of the present application;
FIG. 11 is schematic view showing the assembled structure of the acoustic panel being mounted to the housing wall of the air duct main body according to the embodiment of the present application;
FIG. 12 is a schematic view showing the assembled structure of an acoustic panel formed by two partitions spliced together according to an embodiment of the present application;
FIG. 13 is a schematic view showing the structure where a second hanging portion and an acoustic panel are provided in a split type and are fixedly connected with each other according to an embodiment of the present application;
FIG. 14 is a schematic view showing a second hanging portion and an acoustic panel being of an integral structure according to an embodiment of the present application;
FIG. 15 is a schematic view showing the split structure of an acoustic panel formed by two partitions spliced together according to an embodiment of the present application; and
FIG. 16 is a schematic view showing the structure of an air inlet grille arranged on an acoustic panel according to an embodiment of the present application.

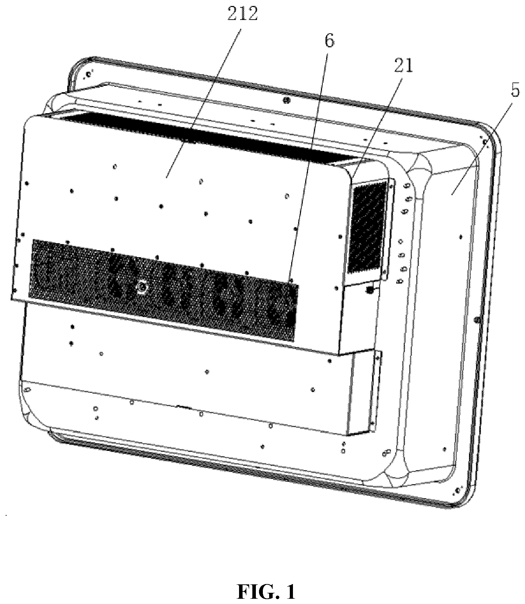

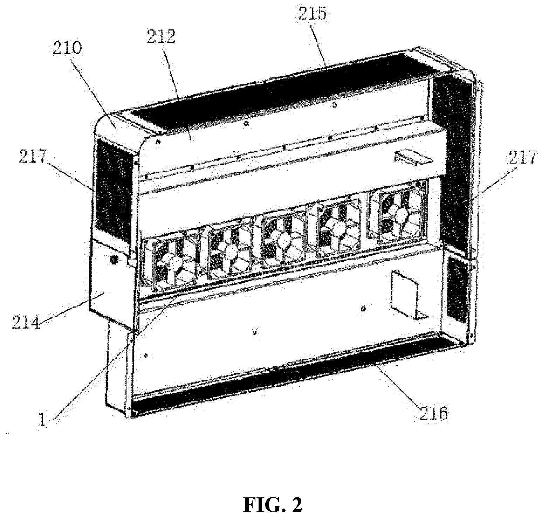

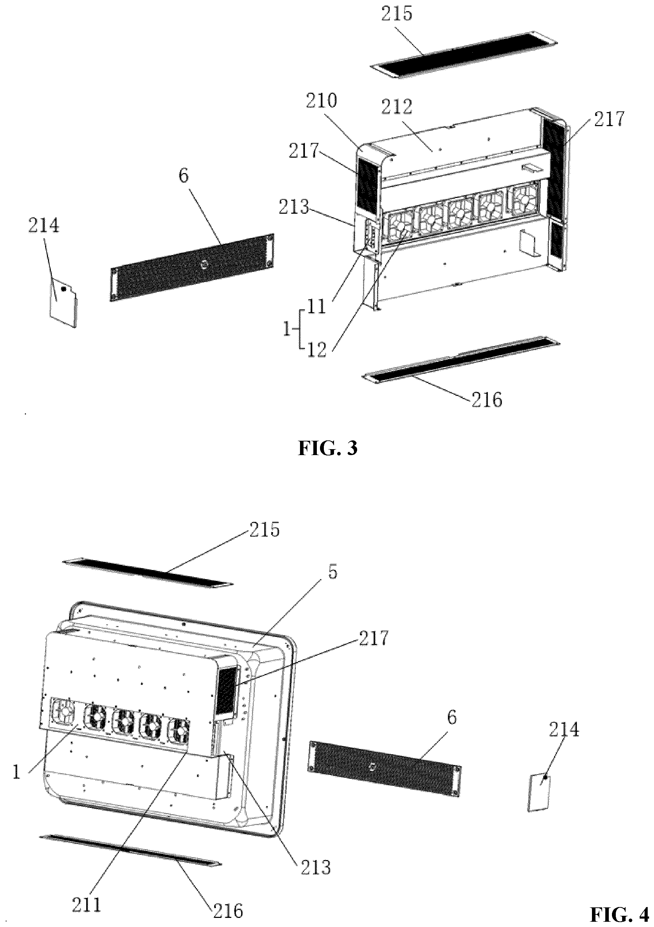

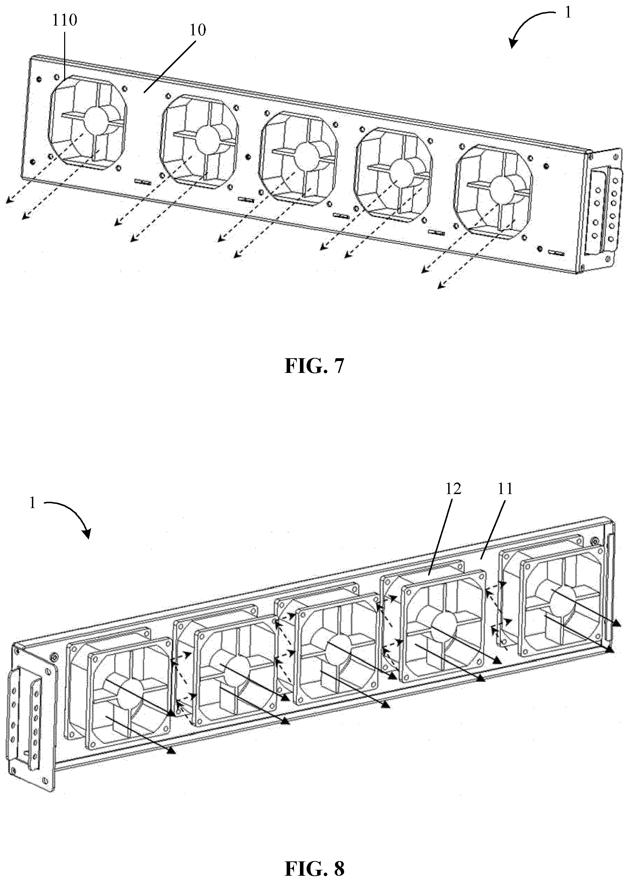

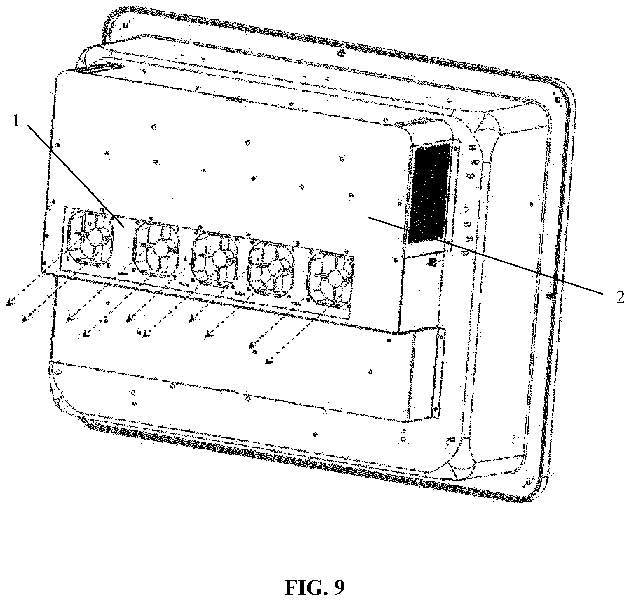

In FIGS. 7 to 11, solid line arrows illustrate airflow directions, and dotted line arrows illustrate propagation directions of acoustic waves. Reference numerals in FIGS. 1 to 16 are as follows:

| | | | |
|---|---|---|---|
| 1 | fan module, | 10 | air inlet side end face, |
| 11 | fan support, | 110 | ventilation opening, |
| 12 | heat dissipation fan, | 2 | air duct main body, |
| 21 | air duct back housing, | 210 | back housing main body, |
| 211 | air inlet opening, | 212 | back wall, |
| 213 | pull-push opening, | 214 | closing plate, |
| 215 | top wall, | 216 | bottom wall, |
| 217 | lateral wall, | 3 | acoustic panel, |
| 30 | partition, | 31 | air inlet grille, |
| 4 | hanging assembly, | 41 | first hanging portion, |
| 42 | second hanging portion, | 5 | enclosure, |

| | | | |
|---|---|---|---|
| 6 | air inlet mesh guard. | | |

### DETAILED DESCRIPTION OF THE EMBODIMENTS

The focus of the present application is to provide a heat dissipation structure, power conversion equipment and a photovoltaic system, to solve the problems of the heat dissipation structure of the electrical equipment that operation for maintaining the air duct is cumbersome and power production is lost.

Technical solutions according to the embodiments of the present application will be described clearly and completely as follows in conjunction with the accompany drawings in the embodiments of the present application. It is obvious that the described embodiments are only a part of the embodiments according to the present application, rather than all of the embodiments. All the other embodiments obtained by those skilled in the art based on the embodiments in the present application without any creative work belong to the scope of protection of the present application.

It may be appreciated by those skilled in the art that, for the electrical equipment that are mounted by hanging on a wall or on a rack, a heat dissipation air duct structure thereof is generally arranged at a back side of an enclosure 5 of the electrical equipment. However, a space for operation at the back side of the enclosure 5 is relatively narrow, thus clearing of the heat dissipation air duct structure can only be performed after the electrical equipment is shut down, the electricity is cut off and the electrical equipment is dismounted. Therefore, operation for maintaining and clearing the heat dissipation air duct structure is very difficult. Certainly, apart from the electrical equipment hung on the wall or on the rack having the above problem of difficult operation, the similar problem also arises in other heat dissipation air duct structures which are mounted in a situation that the operation space is narrow.

Based on this, a heat dissipation structure is provided in the present application. Referring to FIGS. 1 to 6, the heat dissipation structure includes an air duct back housing 21, a fan module 1 and an air inlet mesh guard 6. The air duct back housing 21 is arranged at a back side of an enclosure 5 of electrical equipment to define, together with the enclosure 5, an air duct cavity. An air inlet opening 211 is provided on the air duct back housing 21, and airflow from an external environment enters into the air duct cavity through the air inlet opening 211. The fan module 1 is arranged in the air duct back housing 21 to provide power for airflow circulation in the air duct cavity, and the fan module 1 has an air inlet face fitting the air inlet opening. The air inlet mesh guard 6 is arranged at the air inlet opening 211 in a manner that mounting and dismounting of the air inlet mesh guard 6 is able to be performed at an outer side of the air duct back housing 21. The air inlet mesh guard 6 is mainly used for preventing foreign matters such as willow catkins, aspen catkins, cotton, fluff or the like from getting into the air duct cavity.

In actual applications of the heat dissipation structure, even if the electrical equipment is mounted by hanging on a wall or on a rack, and the air duct back housing 21 is mounted at the back side of the enclosure 5 of the electrical equipment, since the air inlet mesh guard 6 is arranged at the air inlet opening 211 in the manner that mounting and dismounting of the air inlet mesh guard 6 can be performed at the outer side of the air duct back housing 21, in a case that the heat dissipation structure needs to be cleared, there is no need to shut down the electrical equipment, instead, it is only needed to dismount the air inlet mesh guard 6 for clearing. Hence, the operation is very simple, and loss of power production due to shut-down is prevented.

In some specific solutions, referring to FIGS. 1 to 5, the air inlet mesh guard 6 may be arranged on a back wall 212 of the air duct back housing 21 in a detachable manner. With this structural design, mounting and dismounting of the air inlet mesh guard 6 becomes simpler, which facilitates the arrangement. The detachable manner of the air inlet mesh guard 6 being arranged on the back wall 212 may be, but is not limited to, one or a combination of at least two of detachable connection manners such as a sliding fit manner by pushing and pulling in a plane where the air inlet mesh guard 6 is located, a fixed connection manner by a fastener, a clamping connection manner and the like. For example, the air inlet mesh guard 6 is in a sliding fit with the back wall 212 by being pushed and pulled from a lateral portion of the air duct back housing 21 in a plane where the air inlet mesh guard 6 is located. The specific structural form of the sliding fit may be that, a first slide groove and a second slide groove are provided on the back wall 212, an upper edge of the air inlet mesh guard 6 is in a sliding fit with the first slide groove, and a lower edge of the air inlet mesh guard 6 is in a sliding fit with the second slide groove. Certainly, the structural form may be other forms of sliding fit for example, a slide rail is provided on the back wall 212, and a slide groove fitted with the slide rail is provided on the air inlet mesh guard 6, which is not specifically limited herein. Wiring of electrical equipment is usually provided at a bottom portion thereof, with the above sliding fit by pulling toward the lateral portion, mounting and dismounting operation of the air inlet mesh guard 6 becomes more convenient, and interference between the air inlet mesh guard 6 being pulled out and wiring of the electrical equipment is prevented. Certainly, it may be appreciated that, apart from being pulled out and pushed in from the lateral portion, other direction of pushing and pulling may be adopted in a case that other arrangements are required, which is not specifically limited herein.

It should be noted that, the above push-pull sliding fit manner may be combined with at least one of a fixed connection manner by a fastener and a clamping connection manner. For example, the air inlet mesh guard 6 slides to a position at which the air inlet mesh guard 6 is required to be locked, and is fixed and locked by a fastener or a clamping structure. When the air inlet mesh guard 6 is needed to be dismounted and pulled out, just unfasten the fastener or the clamping structure, and the air inlet mesh guard 6 can be pulled out and then dismounted. The fastener or the clamping structure may be arranged at a region convenient for operation at the lateral portion of the air duct back housing 21.

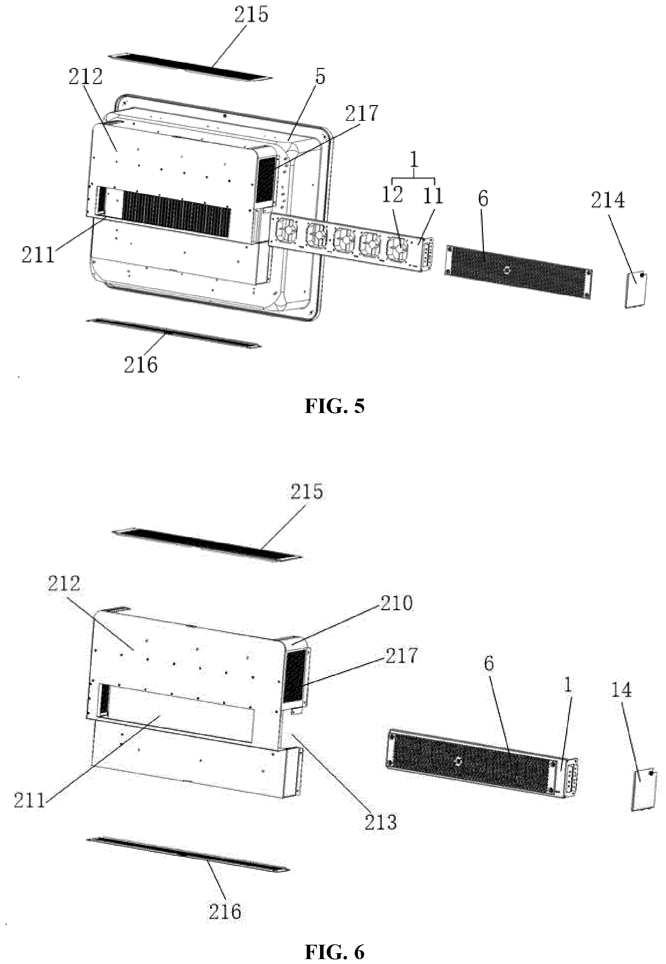

In some specific solutions, referring to FIGS. 5 and 6, the fan module 1 may be arranged at the air duct back housing 21 in a sliding fit manner that the fan module 1 is allowed to be pushed and pulled in a plane where the air inlet mesh guard 6 is located. For example, the fan module 1 is configured to be pulled out with respect to the air duct back housing 21 toward the lateral portion of the air duct back housing 21. The specific structural form of the push-pull sliding fit may be but is not limited to the following solution that, a first slideway and a second slideway are provided on the air duct back housing 21, a top portion of the fan module 1 is in a sliding fit with the first slideway, and a bottom portion of the fan module 1 is in a sliding fit with the second slideway. Certainly, other structural forms of sliding fit may be employed, which is not specifically limited herein. With the fan module 1 being provided in the detachable manner by push-pull sliding fit, it is easier to dismount the fan module 1 for clearing, moreover, clearing of other heat dissipation devices in the air duct cavity defined by the air duct back housing 21 and the enclosure 5 is also easier. Taking an inverter as an example of the electrical equipment, when the fan module 1 is dismounted, a radiator, a reactor and other heat dissipation devices in the air duct cavity defined by the air duct back housing 21 and the enclosure 5 are exposed, which facilitates clearing of these components.

In other specific solutions, the lateral portion of the air duct back housing 21 is further provided with a pull-push opening 213 and a closing plate 214 arranged at the pull-push opening 213 in a detachable manner for closing the pull-push opening 213. By providing the pull-push opening 213 and the closing plate 214, the air duct back housing 21 is ensured to be closed in an operation state, which improves neatness in appearance of the air duct back housing 1 and prevent the fan module 1 from falling.

In some specific solutions, referring to FIG. 6, in the case that the fan module 1 is arranged at the air duct back housing 21 in the sliding fit manner that the fan module 1 can be pushed and pulled in the plane where the air inlet mesh guard 6 is located, the above air inlet mesh guard 6 is arranged at the air inlet face of the fan module 1 and can be pushed and pulled together with the fan module 1 with respect to the air duct back housing 21. With the above structural form, the fan module 1 and the air inlet mesh guard 6 can be mounted and dismounted together, which makes mounting and dismounting operation more convenient.

It should be noted that, the above fan module 1 specifically includes a fan support 11 and at least one heat dissipation fan 12 arranged on the fan support 11. The number of the heat dissipation fan 12 mounted on the fan support 11 may be determined according to actual requirements. The heat dissipation fan 12 and the fan support 11 may be of an integral structure, or may be provided as separate parts that are detachably connected through clamping connection, a fastener or the like, which can be chosen according to requirements in actual applications. The air inlet mesh guard 6 is arranged on the fan support 11 and covers an air inlet side end face of the heat dissipation fan 12. By arranging the at least one heat dissipation fan 12 on the fan support 11, in a case that the number of the heat dissipation fan 12 is plural, the multiple heat dissipation fans 12 forms an integral module, which makes mounting and dismounting more convenient. Furthermore, the air inlet mesh guard 6 is mounted on the fan support 11, which makes mounting and dismounting of the air inlet mesh guard 6 more convenient. For example, the air inlet mesh guard 6 may be directly fixed on the fan support 11 by a fastener, or by other fixation manners generally used by those skilled in the art, such as clamping connection or the like.

In some more specific solutions, referring to FIGS. 1 to 6, the air duct back housing 21 specifically includes a back housing main body 210, a top wall 215 arranged at a top portion of the back housing main body 210, a bottom wall 216 arranged at a bottom portion of the back housing main body 210, and a lateral wall 217 arranged at a lateral portion of the back housing main body 210. The top wall 215 and the back housing main body 210 are connected in a detachable manner; the bottom wall 216 and the back housing main body 210 are connected in a detachable manner; and the lateral wall 217 and the back housing main body 210 are connected in a detachable manner. With the above structural form, it is more convenient for the user to clear the heat dissipation devices in the air duct cavity defined by the air duct back housing 21 and the enclosure 5. In an example, when the top wall 215 is opened, it is easy to clear the heat dissipation devices in correspondence to the top portion in the air duct cavity. In another example, when the bottom wall 216 is opened, it is easy to clear the heat dissipation devices in correspondence to the bottom portion in the air duct cavity. And in yet another example, when the lateral wall 217 is opened, it is easy to clear the heat dissipation devices in correspondence to the lateral portion in the air duct cavity.

In a further solution, to further improve heat dissipation effect of the heat dissipation structure, at least one of the top wall, the bottom wall and the lateral wall is configured to be a ventilation mesh guard structure. With the above structural form, the air duct cavity has a better ventilation performance, and the heat dissipation effect is improved.

It should be noted that, the detachable connection manner between the top wall 215 and the back housing main body 210 may be but is not limited to one or a combination of at least two of multiple manners, such as a sliding fit manner by pushing and pulling, a fixed connection manner by a fastener, a clamping connection manner and the like. Similarly, the detachable connection manner between the bottom wall 216 and the back housing main body 210 may be but is not limited to one or a combination of at least two of multiple manners, such as a sliding fit manner by pushing and pulling, a fixed connection manner by a fastener, a clamping connection manner and the like. In addition, the detachable connection manner between the lateral wall 217 and the back housing main body 210 may be but is not limited to one or a combination of at least two of multiple manners, such as a sliding fit manner by pushing and pulling, a fixed connection manner by a fastener, a clamping connection manner and the like.

Moreover, the heat dissipation fan 12 in the heat dissipation structure generally produces loud noise, for example, a harsh sound, which definitely causes noise pollution to the environment. To reduce the noise of the heat dissipation structure, the following solutions are provided.

Referring to FIGS. 7 to 17, a heat dissipation structure is provided in the present application, including a fan module 1 and an acoustic panel 3. The fan module 1 provides power for airflow circulation in an air duct main body 2. The acoustic panel 3 is arranged at an outer side of the air duct main body 2 and faces an air inlet side end face 10 of the fan module 1. The acoustic panel 3 may, but is not limited to, be arranged exactly facing the air inlet side end face 10 of the fan module 1. An air inlet gap is provided between the acoustic panel 3 and the air inlet side end face 10 of the fan module 1, to ensure that airflow from an exterior can be smoothly sucked into the air duct main body 2 by the fan module 1. The acoustic panel 3 is generally made of a sound insulation material, or a sound insulation material is provided at a face of the acoustic panel 3 facing the air inlet side end face 10 of the fan module 1.

In actual applications of the heat dissipation structure, since the acoustic panel 3 is arranged facing the air inlet side end face of the fan module 1, the acoustic panel 3, by its own sound insulation performance, can prevent noise produced by the fan module 1 during air inlet process from propagating toward the outer side of the air duct main body 2, thereby beneficial to reducing the noise of the heat dissipation structure of the electrical equipment.

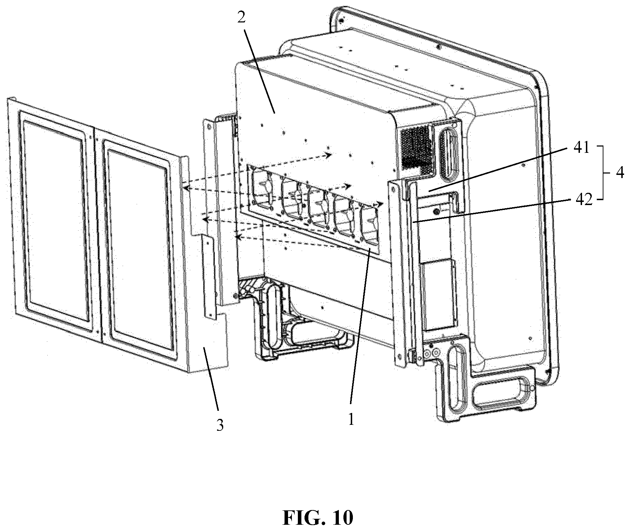

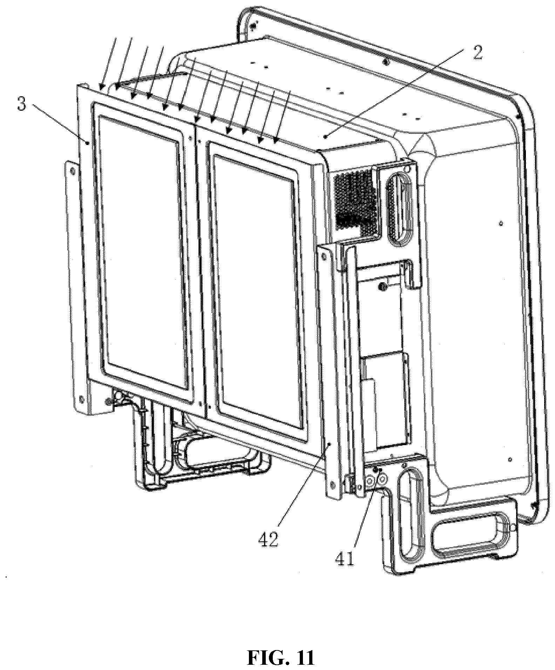

In some specific solutions, referring to FIGS. 10 and 11, an air inlet cavity is defined by the acoustic panel 3 and a housing of the air duct main body 2, and the air inlet cavity has an air inlet opening. Airflow from the exterior enters into the air inlet cavity through the air inlet opening, and then is sucked into the air duct main body 2 by the fan module 1. The air inlet cavity provides buffering to the airflow to some extent, which is beneficial to improving air inlet effect. Furthermore, the air inlet direction can be flexibly adjusted, which can better satisfy air return of the heat dissipation structure. It should be understood that, the housing of the air duct main body 2 in the solutions illustrated in FIGS. 7 to 17 actually refers to the air duct back housing in the solutions illustrated in FIGS. 1 to 6.

In a further solution, referring to FIGS. 10 and 11, the air inlet opening may be formed at a top portion of the air inlet cavity, i.e. the airflow is controlled to be sucked via the top portion of the air inlet cavity. Specifically, flanges may be formed at the acoustic panel 3 by a bottom portion and two sides of the acoustic panel 3 being bent toward the housing of the air duct main body 2, such that the air inlet opening provided at the top portion is formed after the acoustic panel 3 is mounted at the housing of the air duct main body 2. Certainly, it may be appreciated that, the above structural form is merely an example of the embodiments of the present application. In actual applications, the air inlet cavity may be of other structural forms, for example, plates may be provided on the housing of the air duct main body 2 toward the acoustic panel 3 to surround the acoustic panel 3, which is not specifically limited herein. It should be noted that, the above manner that air being introduced via the top portion is merely an example for the airflow inlet direction in the embodiments of the present application. In actual applications, manners that air being introduced via a bottom portion or a lateral portion may be selected according to actual airflow arranging requirements, which is not specifically limited herein.

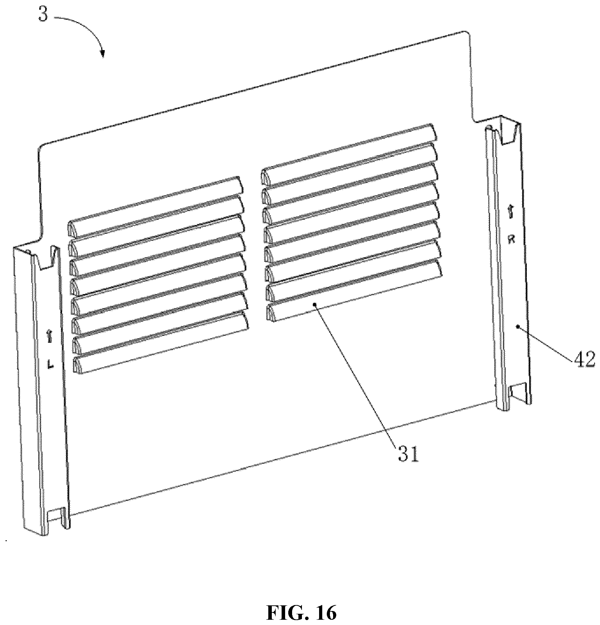

In some specific solutions, referring to FIG. 16, the acoustic panel 3 may be provided with an air inlet grille 31 or air inlet mesh holes. With the air inlet grille 31 or the air inlet mesh holes provided on the acoustic panel 3, the amount of air inlet is increased, and air pressure and the noise are reduced as well. The specific structural form of the air inlet mesh holes is not specifically limited herein.

In some specific solutions, referring to FIGS. 7 and 8, the fan module 1 is specifically arranged at an inner side of the air duct main body 2 of the electrical equipment, and the air inlet side end face 10 of the fan module 1 is fitted with an air duct inlet of the air duct main body 2. With the modular structure of the fan module 1, not only mounting and maintenance are facilitated, but also the noise produced by the fan during operation can be at least partially absorbed.

In a further solution, referring to FIGS. 7 and 8, the fan module 1 specifically includes a fan support 11 arranged at the inner side of the air duct main body 2 and at least one heat dissipation fan 12 arranged on the fan support 11. The number of the heat dissipation fan 12 on the fan module 1 may be one or plural, which can be determined according to actual requirements in actual applications, and is not specifically limited herein. Moreover, by arranging the at least one heat dissipation fan 12 on the fan support 11, part of the noise produced during operation of the heat dissipation fan 12 can be absorbed or reflected, which is beneficial to reducing the noise.

In a further solution, referring to FIG. 7, preferably, an air inlet side of the heat dissipation fan 12 is fixed on the fan support 11, and the fan support 11 is provided with an ventilation opening 110 fitting an air inlet face of the heat dissipation fan 12. With the above structural form, an air duct inside the heat dissipation fan 12 itself is also located inside the air duct main body 2, which is beneficial to reducing propagation of the noise, produced by the heat dissipation fan 12 during operation, to the outer side of the air duct main body 2.

In a yet further solution, referring to FIG. 7, an opening area of the ventilation opening 110 is preferably smaller than an area of the air inlet face of the at least one heat dissipation fan 12. With the above structural form, propagation of the noise, produced by the heat dissipation fan 12 during operation, to the outer side of the air duct main body 2 is further reduced.

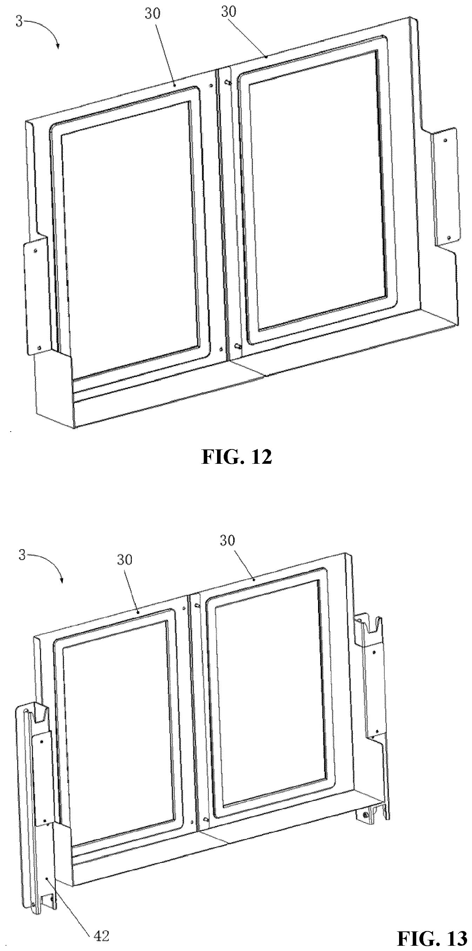

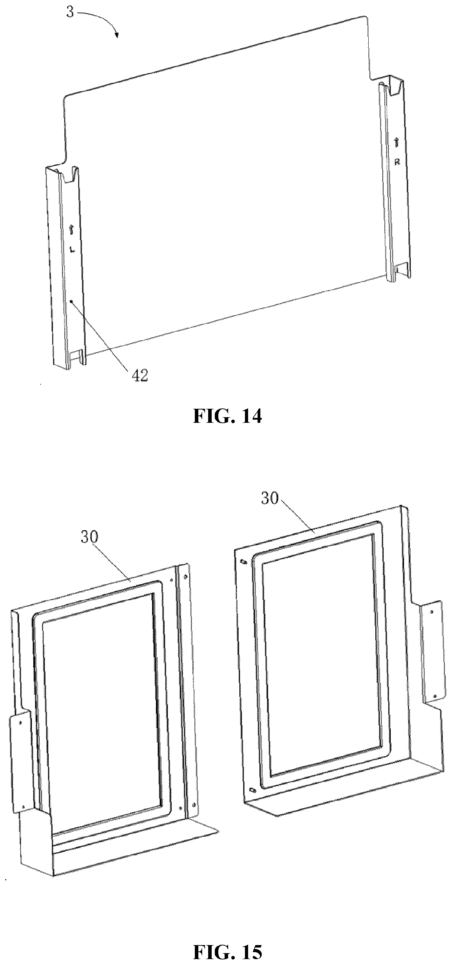

It should be noted that, the acoustic panel 3 may be specifically of an integral structure as shown in FIGS. 14 and 16, which makes the structure of the acoustic panel 3 more stable, and is more applicable to a case that the size of the acoustic panel 3 is relatively small or medium. Certainly, it may be appreciated that, the acoustic panel 3 may be formed by at least two partitions 30 being spliced and connected together as shown in FIGS. 12, 13 and 15, which is more applicable to a case that the size of the acoustic panel 3 is relatively large. With the structural form of separate parts being fixedly connected, packaging and transportation of components become more convenient, and the requirement for the size of raw material for the acoustic panel can be lower.

Moreover, it should be noted that, in the case that the acoustic panel is formed by the at least two partitions 30 being spliced and connected together, the connection manner between two adjacent partitions 30 may, but is not limited to, a connection by a fastener or a hinge.

In some more specific solutions, referring to FIGS. 10 and 11, the acoustic panel 3 is specifically mounted by hanging on the housing of the air duct main body 2 via a hanging assembly 4. With the above structural form, mounting and dismounting of the acoustic panel 3 becomes simpler. Certainly, it may be appreciated that, the above hanging manner via the hanging assembly 4 is merely an example for mounting the acoustic panel 3 in the embodiments of the present application. In actual applications, other mounting manners usually used by those skilled in the art may be adopted, which is not specifically limited herein.

In a further solution, referring to FIGS. 10 and 11, in conjunction with FIGS. 13 and 14, the hanging assembly 4 specifically includes a first hanging portion 41 provided on the housing of the air duct main body 2, and a second hanging portion 42 provided on the acoustic panel 3, where the first hanging portion 41 and the second hanging portion 42 are connected in a hanging manner. The first hanging portion 41 and the housing of the air duct main body 2 are of an integral structure, or may be of separate parts being fixedly connected. Similarly, the second hanging portion 42 and the acoustic panel 3 may be of an integral structure, or may be of separate parts being fixedly connected. With the above structural form, the hanging assembly 4 may be provided as an optional accessory, which further facilitates packaging, mounting and maintenance.

Moreover, power conversion equipment is further provided in the present application, as shown in FIG. 1, including an enclosure 5, a power conversion circuit mounted in the enclosure 5, and a heat dissipation structure arranged at a back side of the enclosure 5, where the heat dissipation structure is according to any one of the above solutions. Since the heat dissipation structure described hereinabove has the above technical effects, the power conversion equipment having the heat dissipation structure also has corresponding technical effects, which will not be described herein.

It should be noted that, the power conversion equipment may specifically be a DC-DC converter, or a DC-AC converter, which may be applied to different situations according to actual requirements in actual applications. The DC-AC converter, i.e. an inverter is taken as an example, there is a power conversion circuit inside the inverter, and a power device in the power conversion circuit produces heat during operation. Therefore, a heat dissipation air duct is provided inside the inverter, through which the heat generated by the power device can be dissipated, to ensure normal operation of the power device. The fan module 1 is one of power sources for discharging air in the heat dissipation air duct.

Moreover, a photovoltaic system is further provided in the present application, including the power conversion equipment described in the above solution. Since the above power conversion equipment has the above technical effects, the photovoltaic system having the power conversion equipment also has corresponding technical effects, which will not be described herein.

A photovoltaic inverter is taken as an example of the power conversion equipment, as conversion equipment of a photovoltaic power station, the photovoltaic inverter has important functions and plays an important role in the whole power station. The photovoltaic inverter converts a direct current generated by a photovoltaic module into a sinusoidal current which is connected to a load or to the grid, and the photovoltaic inverter is a core device of the photovoltaic system.

It should be noted that, the above embodiments in this specification are described in a progressive manner. Each of the embodiments is mainly focused on describing its differences from other embodiments, and references may be made among these embodiments with respect to the same or similar portions among these embodiments.

As described in the present application, unless exceptional cases explicitly indicated in the content, terms "a", "one", "a type" and/or "such" are not intended to refer to a single one, and may include a plural case. In general, terms "include", "comprise" are merely intended to include the explicitly listed steps and factors, while these steps and factors do not constitute a non-exclusive list, and the method or the device may include other steps and factors. A factor defined by "include one..." does not exclude a case that there is another same factor in the process, the method, the product or the device including the described factor.

In the description of the embodiments of the present application, unless otherwise noted, "/" indicates the meaning of "or". For example, A/B may indicate A or B. The term "and/or" herein only indicates correlation relationships of describing correlated objects, and indicates that there may be three correlation relationships. For example, the term "A and/or B" indicates three cases, namely only A exists, A and B exist at the same time, and only B exists. In addition, in the descriptions in the embodiments of the present application, the term "multiple" indicates two or more than two.

In addition, terms such as "first", "second" and the like are merely for description, and should not be construed as indicating or implying relative importance, or implicitly indicating the number of technical features being referred to. Therefore, the feature defined by the terms "first" and "second" may explicitly or implicitly include one or more such features.

The principle and the embodiments of the present application are illustrated herein by specific examples. The above descriptions of examples are only intended to help the understanding of the main idea of the present application. It should be noted that, for those skilled in the art, a few of modifications and improvements may be made to the present application without departing from the principle of the present application, and these modifications and improvements are also deemed to fall into the scope of the present application defined by the claims.

## Claims

1. A heat dissipation structure, comprising:
an air duct back housing (21), configured to be arranged at a back side of an enclosure (5) of electrical equipment, wherein an air inlet opening (211) is provided on the air duct back housing (21);
a fan module (1), being arranged in the air duct back housing (21), wherein the fan module (1) has an air inlet face fitting the air inlet opening (211); and
an air inlet mesh guard (6), being arranged at the air inlet opening (211) in a manner that the air inlet mesh guard (6) is allowed to be mounted and dismounted from an outer side of the air duct back housing (21).

2. The heat dissipation structure according to claim 1, wherein the air inlet mesh guard (6) is arranged on a back wall (212) of the air duct back housing (21) in a detachable manner.

3. The heat dissipation structure according to claim 2, wherein the detachable manner of the air inlet mesh guard (6) being arranged on the back wall (212) comprises one or a combination of at least two of three manners, namely a sliding fit manner by pushing and pulling in a plane where the air inlet mesh guard (6) is located, a fixed connection manner by a fastener, and a clamping connection manner.

4. The heat dissipation structure according to claim 3, wherein the air inlet mesh guard (6) is fitted with the back wall (212) in the sliding fit manner that the air inlet mesh guard (6) is allowed to be pushed and pulled with respect to the back wall (212) from a lateral portion of the air duct back housing (21) in the plane where the air inlet mesh guard (6) is located.

5. The heat dissipation structure according to claim 4, wherein a first slide groove and a second slide groove are provided on the back wall (212), an upper edge of the air inlet mesh guard (6) is in a sliding fit with the first slide groove, and a lower edge of the air inlet mesh guard (6) is in a sliding fit with the second slide groove.

6. The heat dissipation structure according to claim 1, wherein the fan module (1) is arranged in the air duct back housing (21) in a sliding fit manner that the fan module (1) is allowed to be pushed and pulled along a plane where the air inlet mesh guard (6) is located.

7. The heat dissipation structure according to claim 6, wherein the fan module (1) is configured to be pulled out with respect to the air duct back housing (21) toward a lateral portion of the air duct back housing (21).

8. The heat dissipation structure according to claim 7, wherein a first slideway and a second slideway are provided on the air duct back housing (21), a top portion of the fan module (1) is in a sliding fit with the first slideway, and a bottom portion of the fan module (1) is in a sliding fit with the second slideway.

9. The heat dissipation structure according to claim 7, wherein the lateral portion of the air duct back housing (21) is provided with a pull-push opening (213), and a closing plate (214) arranged at the pull-push opening (213) in a detachable manner for closing the pull-push opening (213).

10. The heat dissipation structure according to claim 6, wherein the air inlet mesh guard (6) is arranged at the air inlet face of the fan module (1), and is allowed to be pushed and pulled together with the fan module (1) with respect to the air duct back housing (21).

11. The heat dissipation structure according to claim 10, wherein the fan module (1) comprises a fan support (11) and at least one heat dissipation fan (12) arranged on the fan support (11), wherein the air inlet mesh guard (6) is arranged at the fan support (11) and covers an air inlet side end face of the at least one heat dissipation fan (12).

12. The heat dissipation structure according to any one of claims 1 to 10, wherein
the air duct back housing (21) comprises a back housing main body (210), a top wall (215) arranged at a top portion of the back housing main body (210), a bottom wall (216) arranged at a bottom portion of the back housing main body (210), and a lateral wall (217) arranged at a lateral portion of the back housing main body (210); wherein
the top wall (215) and the back housing main body (210) are connected in a detachable manner; and/or
the bottom wall (216) and the back housing main body (210) are connected in a detachable connection manner; and/or
the lateral wall (217) and the back housing main body (210) are connected in a detachable connection manner.

13. The heat dissipation structure according to claim 12, wherein at least one of the top wall (215), the bottom wall (216) and the lateral wall (217) is configured to be a ventilation mesh guard structure.

14. Power conversion equipment, comprising an enclosure (5) and the heat dissipation structure according to any one of claims 1 to 12, wherein the heat dissipation structure is arranged at a back side of the enclosure (5).

15. A photovoltaic system, comprising the power conversion equipment according to claim 14.
